# EUROPEAN PATENT APPLICATION

(11) **EP 1 536 637 A1**
(43) Date of publication of application: **01.06.2005**
(21) Application number: 04027908.5
(22) Date of filing: 24.11.2004
(51) Int. Cl.: H04N 5/60, H04N 5/445

(54) **Audio outputting method and apparatus**

(30) Priority: 28.11.2003 JP 2003400891
(71) Applicant: Kabushiki Kaisha Toshiba, Tokyo 105-8001 (JP)
(72) Inventor: Wakabayashi, Hidenori, Minato-ku Tokyo 105-8001 (JP)
(74) Representative: Henkel, Feiler & Hänzel

(57) **Abstract**

The present invention provides an audio outputting apparatus, including an audio reproducing section (15) configured to reproduce an audio signal from an input signal, setting sections (20 to 23) configured to set a limitation level for the audio signal reproduced by the audio reproducing section, an audio controlling section (18) configured to detect that a level of the audio signal reproduced by the audio reproducing section exceeds a limitation level set by the setting sections, and configured to apply a limitation processing to a portion of the audio signal reproduced by the audio reproducing section exceeding the limitation level based on a detection result of the audio level detection.

## Description

The present invention relates to an audio outputting apparatus and an audio outputting method of restoring an audio signal from an input signal and outputting the audio signal.

As is well known, for example, during watching a television broadcast program, an audio volume is rapidly increased due to a sound effect or when a program content is switched from a main story into a commercial and a TV audience may be forced to decrease an audio volume immediately.

With respect to this problem, Jpn. Pat. Appln. KOKAI Publication No. 5-226953 discloses a configuration to reduce an output audio level with respect to a high level of audio input by a compressor having an input and output property of nonlinear and control an audio volume within a predetermined scope.

However, according to this configuration disclosed in Jpn. Pat. Appln. KOKAI Publication No. 5-226953, all levels of the input audio are controlled by the compressor and a small level of the input audio is further controlled into a smaller level, so that this configuration is not suitable for practical use.

The present invention has been made taking the foregoing problems into consideration and an object of which is to provide an audio outputting apparatus and an audio outputting method, which can effectively control rapid increase of an audio volume and is sufficiently preferable for practical use.

According to one aspect of the present invention, there is provided an audio outputting apparatus, comprising: an audio reproducing section configured to reproduce an audio signal from an input signal; setting sections configured to set a limitation level for the audio signal reproduced by the audio reproducing section a detecting section configured to detect that a level of the audio signal reproduced by the audio reproducing section exceeds a limitation level set by the setting sections; and a limiting section configured to apply the limitation processing to a portion of the audio signal reproduced by the audio reproducing section exceeding the limitation level based on a detection result of the detecting section.

According to another aspect of the present invention, there is provided an audio outputting method, comprising: a first step of reproducing an audio signal from an input signal; second steps of setting a limitation level for the audio signal reproduced by the first step; a third step of detecting that a level of the audio signal reproduced by the first step exceeds a limitation level set by the second steps; and a fourth step of applying the limitation processing to a portion of the audio signal reproduced by the first step exceeding the limitation level based on a detection result of the third step.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a block diagram showing a digital television broadcast receiver according to an embodiment of the present invention;
FIG. 2 is an outside drawing showing a remote controller of the digital television broadcast receiver according to the embodiment;
FIG. 3 shows an example of an audio control selection menu displayed by the digital television broadcast receiver according to the embodiment;
FIG. 4 shows an example of an audio setting menu displayed by the digital television broadcast receiver according to the embodiment;
FIG. 5 shows an example of a state that an audio volume is set on an audio setting menu displayed by the digital television broadcast receiver according to the embodiment;
FIG. 6 shows a limitation of an amplitude level of an analog audio signal carried out by the digital television broadcast receiver according to the embodiment;
FIG. 7 is a flow chart showing main operation carried out by the digital television broadcast receiver according to the embodiment;
FIG. 8 is a characteristic diagram showing a relationship between an audio volume of the digital television broadcast receiver and a digital audio signal according to the embodiment; and
FIG. 9 shows a limitation of a level of a digital audio signal carried out by the digital television broadcast receiver according to the embodiment.

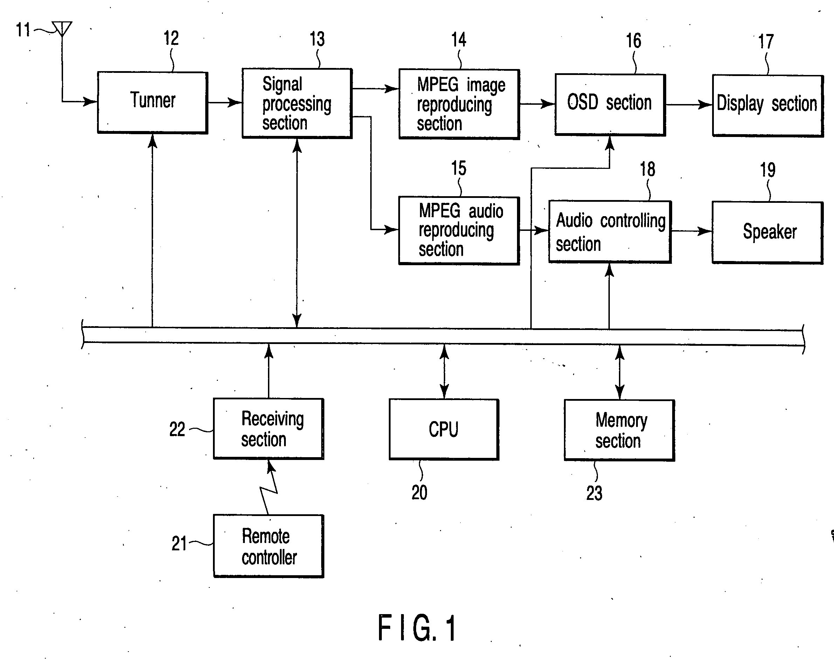

An embodiment of the present invention will be described in detail below. FIG. 1 shows a digital television broadcast receiver described in this embodiment. In other words, a digital television signal received by an antenna 11 is supplied to a tuner 12 and a signal of a specific channel is selected.

A broadcast signal selected by this tuner 12 is supplied to a signal processing section 13. This signal processing section 13 applies error correction processing, scramble release processing and TS (Transport Stream) packet conversion processing to the input broadcast signal. Then, this signal processing section 13 outputs an image signal for each packet to an MPEG (Moving Picture Experts Group) image reproducing section 14 and outputs an audio signal for each packet to an MPEG audio reproducing section 15.

Among these sections, the MPEG image reproducing section 14 may apply the decoding processing corresponding to the compression coding processing to the input image signal and may reproduce an analog image signal, and may output it to an OSD (On Screen Display) section 16. This OSD section 16 superimposes a specific OSD signal on the input image signal, outputs it to a display section 17 composed of a CRT (Cathode Ray Tube) or the like to display the image thereon.

In addition, the above-described MPEG audio reproducing section 15 may apply the decode processing corresponding to the compression coding processing to the input audio signal and may reproduce an analog audio signal, and may output it to an audio controlling section 18.

When a level of the input audio signal is higher than a limitation level that has been set in advance by a user, this audio controlling section 18 may control a voice signal exceeding the limitation level to suppress a level thereof. Then, an audio signal to be output from this audio controlling section 18 is supplied to a speaker 19 and audio is reproduced. Thereby, the audio volume is prevented from being larger than the predetermined audio volume.

In this case, in this digital television broadcast receiver, all operations including the above-described operations are generally controlled by a CPU (Central Processing Unit) 20. This CPU 20 may receive the operation information transmitted from a remote controller 21 via a receiving section 22 and may control each section so that the operation content is reflected.

In this case, the CPU 20 uses a memory section 23. In other words, this memory section 23 may include a read only memory having a control program executed by the CPU 20 stored therein, a read and write memory of providing an operation area to the CPU 20, and an in volatile memory or the like having various set information and control information or the like therein.

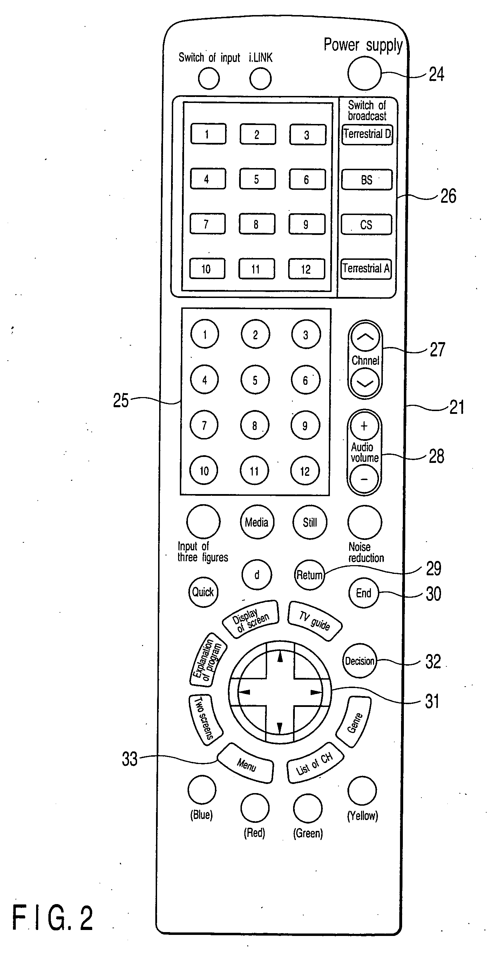

FIG. 2 shows the outline of the remote controller 21. In this remote controller 21, a power supply key 24, a one-touch select key group 25, a receiving mode switch key group 26, a channel up down key 27, an audio volume adjusting key 28, a return key 29, an end key 30, a shift key 31, a decision key 32, and a menu key 33 or the like are mainly set.

In this case, the user can select whether the level control of the audio signal is carried out. In other words, by operating the menu key 33 of the remote controller 21 and sequentially selecting a predetermined item from the menu displayed on the display section 17, the user may display an audio control select menu.

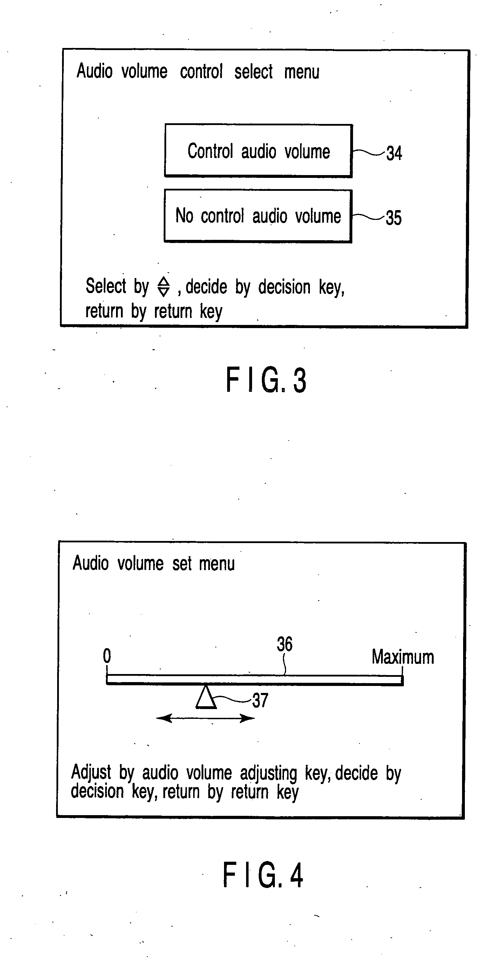

This audio control select menu, as shown in FIG. 3, displays an item 34 of "control audio" and an item 35 of "no control audio". By operating the shift key 31 of the remote controller 21, the user may select any of the items 34 and 35 and by operating the predetermined decision key 32, the user can select whether the level control of the audio signal is controlled by the audio controlling section 18.

In addition, if the item 34 of "control audio" is selected by the audio control select menu, the CPU 20 may display the audio volume set menu on the display section 17. As shown in FIG. 4, this audio volume set menu displays a bar item 36 that a state of "0" of the audio volume corresponds to one end and a state of "the maximum" of the audio volume corresponds to many ends, and an index 37 moving along an item 36 corresponding to the audio volume, so that the audio volume can be grasped visually.

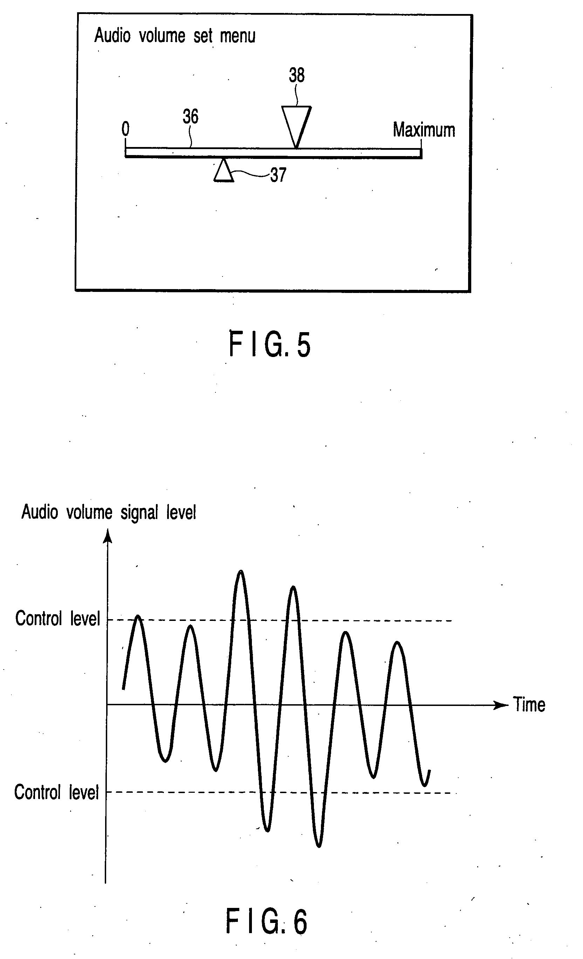

Then, the user may operate the audio volume adjusting key 28 while hearing the audio of the television broadcast program practically, and when acquiring the audio volume, which the user judges preferable, the user may operate the decision key 32. As a result, as shown in FIG. 5, an audio set index 38 is displayed on the item 36, and in this time, an audio volume of which level should be controlled is set.

Thus, if the audio volume of which level should be controlled is set, the CPU 20 may calculate an amplitude level of the audio signal corresponding to the set audio volume, and the CPU 20 may make the in volatile memory or the like of the memory section 23 to hold the calculation result as a limitation level.

Then, as shown in FIG. 6, the audio controlling section 18 may compare the amplitude level of the input audio signal with the-limitation level and may control the audio signal having the amplitude level exceeding the limitation level substantially not to be output by clipping it to the limitation level.

In the meantime, under the state that the item 35 of "no control audio" is selected by the audio control select menu, that is to say, under the state that the audio controlling section 18 is set so as not to carry out the level control of the audio signal, the audio controlling section 18 may operate so as to pass the input audio signal as it is.

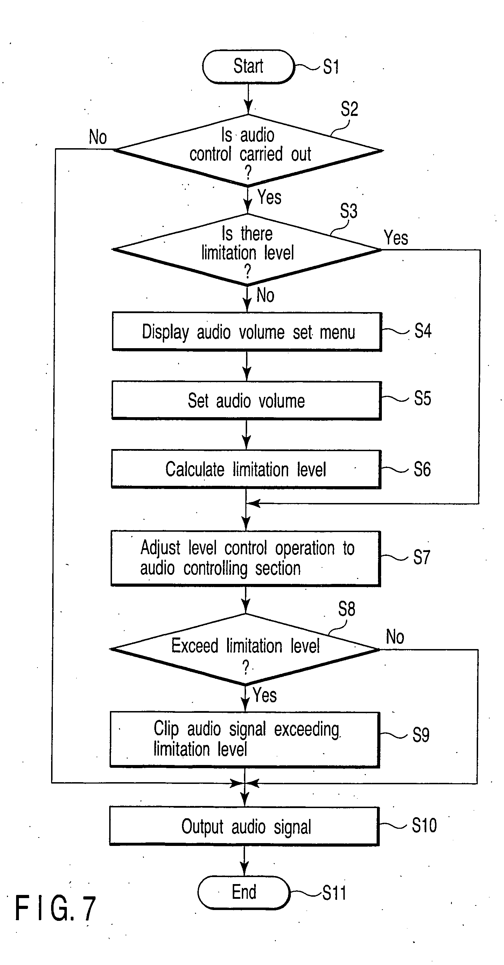

FIG. 7 is a flow chart including main operations of the above-described digital television broadcast program. At first, if the processing is started (step S1), the CPU 20 may determine whether the audio control is set to be done in step S2.

Then, when it is determined that the audio control is not performed (NO), the CPU 20 may control the audio controlling section 18, and making the audio controlling section 18 to output the audio signal in step S10, the CPU 20 may terminate the processing (step S11).

In addition, if it is determined that the audio control should be done in the step S2 (YES), the CPU 20 may determine whether the limitation level is set in step S3.

Then, if it is determined that the limitation level is not set (NO), the CPU 20 may make the audio volume set menu to be displayed on the display section 17 in step S4, and if the audio volume is set in step S5 by the user, the CPU 20 may calculate the amplitude level of the audio signal corresponding to the set audio volume, namely, the limitation level in step S6 and may make the in volatile memory or the like of the memory section 23 to hold it.

After the step S6, or in the case of judging that the limitation level is set in the step S3 (YES), the CPU 20 may instruct the audio controlling section 18 to perform the level control operation in step S7. Thereby, the audio controlling section 18 may judge whether the amplitude level of the input audio signal substantially exceeds the limitation level in step S8.

Then, when it is judged that the amplitude level of the input audio signal substantially exceeds the limitation level (YES), the audio controlling section 18 may clip the audio signal having the amplitude level substantially exceeding the limitation level to the limitation level in step S9.

After the step S9, or when it is judged that the amplitude level of the input audio signal substantially does not exceed the limitation level (NO) in the step S8, the audio controlling section 18 may output an audio signal in the step S10 and the CPU 20 may terminate the processing (step S11).

According to the above-described embodiment, comparing the amplitude level of the audio signal with the predetermined limitation level, the audio signal having the amplitude level substantially exceeding the limitation level is clipped to the limitation level. Therefore, it is possible to effectively suppress rapid increase of the audio volume.

In addition, since the audio signal having the amplitude level substantially exceeding the limitation level is clipped to the limitation level, the audio signal of the amplitude level not exceeding the limitation level substantially is provided for reproduction of the audio as it is without being provided with any level control, so that this audio signal can be sufficiently suitable for practical use.

In the meantime, according to the above-described embodiment, the audio signal having the amplitude level substantially exceeding the limitation level is clipped to the limitation level, however, other than clipping, the audio signal having the amplitude level substantially exceeding the limitation level may be muted.

In addition, according to the above-described embodiment, the level control of the analog audio signal is described, however, for example, even when the digital audio signal is output from the above-described MPEG audio reproducing section 15, it is possible to perform the level control processing to that digital audio signal.

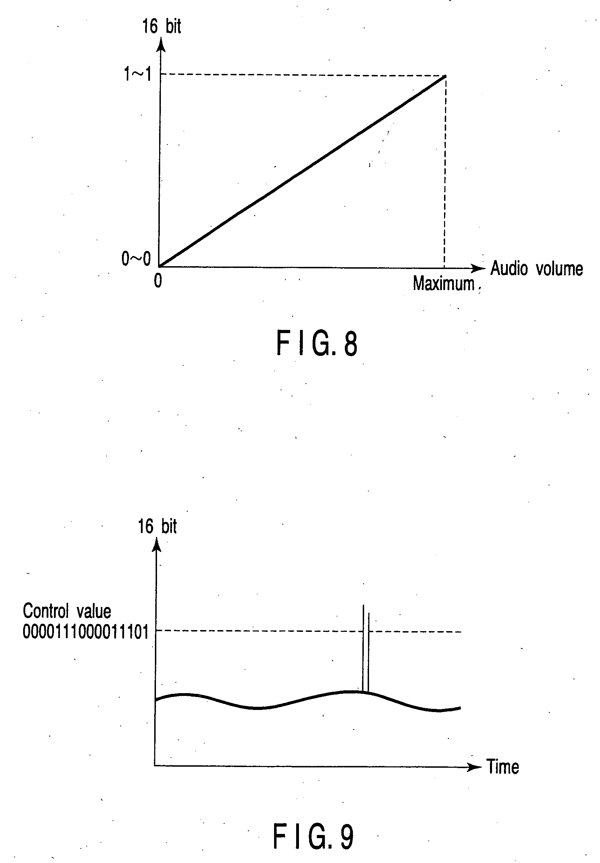

For example, as shown in FIG. 8, it is assumed that from "0" of the audio volume to "the maximum" thereof are set so as to correspond to 16 bit digital audio signal of "0000000000000000" to "1111111111111111".

In this case, as shown in FIG. 9, if the limitation level is set, for example, at "0000111000011101" or the like, it is possible to attenuate the digital audio signal having a value substantially exceeding this limitation level by an attenuator.

In addition, it is also possible to lower the audio volume by adding a signal of the inversed phase of a portion of the digital audio signal exceeding the set value substantially to this portion by using a device of converting the original output audio waveform into an inversed phase other than the attenuator.

Further, according to the above-described embodiment, the case of adopting the present invention to the digital television broadcast receiver is described, however, not limited to this, for example, it is possible to widely adopt the present invention to various devices to reproduce the audio signal recorded in a recording medium such as a tape, a semiconductor memory, and a disk or the like and a device to receive the audio broadcast or the like.

In the meantime, the present invention is not limited to the above-described embodiment as it is, and in the practice stage, various modifications of can be used within a scope of a spirit of the present invention. In addition, by composing a plurality of constituent elements disclosed in the above-described embodiment, various inventions are available. For example, from among all constituent elements of the embodiment, some of them may be deleted. Further, the constituent elements of the different embodiments may be combined appropriately.

## Claims

1. An audio outputting apparatus, **characterized by** comprising:
an audio reproducing section (15) configured to reproduce an audio signal from an input signal;
setting sections (20 to 23) configured to set a limitation level for the audio signal reproduced by the audio reproducing section (15);
a detecting section (18) configured to detect that a level of the audio signal reproduced by the audio reproducing section (15) exceeds a limitation level set by the setting sections (20 to 23); and
a limiting section (18)' configured to apply the limitation processing to a portion of the audio signal reproduced by the audio reproducing section (15) exceeding the limitation level based on a detection result of the detecting section (18).

2. An audio outputting apparatus according to claim 1, **characterized in that** the limiting section (18) applies the processing to lower a level of the audio signal to a portion of the audio signal reproduced by the audio reproducing section (15) exceeding the limitation level.

3. An audio outputting apparatus according to claim 2, **characterized in that**
the limiting section (18) carries out any one of the following processing:
the processing of muting a portion of the audio signal reproduced by the audio reproducing section (15) exceeding the limitation level;
the processing of attenuating a portion of the audio signal reproduced by the audio reproducing section (15) exceeding the limitation level;
the processing of adding a.signal of the inversed phase of a portion of the audio signal reproduced by the audio reproducing section (15) exceeding the limitation level to this portion; and
the processing of clipping a portion of the audio signal reproduced by the audio reproducing section (15) exceeding the limitation level.

4. An audio outputting apparatus according to claim 1, **characterized in that**
the setting sections (20 to 23) comprise calculating sections (20, 28) configured to calculate a level of the audio signal corresponding to an audio volume set by the audio volume adjusting operation; and
a storing section (23) configured to hold the level calculated by the calculating sections (20, 28) as the limitation level.

5. An audio outputting apparatus according to claim 1, **characterized by** further comprising:
selecting sections (20 to 23) configured to make the limiting section (18) select whether the level limitation is applied to the audio signal reproduced by the audio reproducing section (15).

6. An audio outputting method, **characterized by** comprising:
a first step (15) of reproducing an audio signal from an input signal;
second steps (20 to 23, S4, S5) of setting a limitation level for the audio signal reproduced by the first step (15);
a third step (18, S18) of detecting that a level of the audio signal reproduced by the first step (15) exceeds a limitation level set by the second steps (20 to 23, S4, S5); and
a fourth step (18, S9) of applying the limitation processing to a portion of the audio signal reproduced by the first step (15) exceeding the limitation level based on a detection result of the third step (18, S18).

7. An audio outputting method according to claim 6, **characterized in that** the fourth step (18, S9) applies the processing to lower a level of the audio signal to a portion of the audio signal reproduced by the first step (15) exceeding the limitation level.

8. An audio outputting method according to claim 7, **characterized in that** the fourth step (18, S9) carries out any one of the following processing:
the processing of muting a portion of the audio signal reproduced by the first step (15) exceeding the limitation level;
the processing of attenuating a portion of the audio signal reproduced by the first step (15) exceeding the limitation level;
the processing of adding a signal of the inversed phase of a portion of the audio signal reproduced by the first step (15) exceeding the limitation level to this portion; and
the processing of clipping a portion of the audio signal reproduced by the first step (15) exceeding the limitation level.

9. An audio outputting method according to claim 6, **characterized in that** the second steps (20 to 23, S4, S5) comprise fifth steps (20, 28, S6) of calculating a level of the audio signal corresponding to an audio volume set by the audio volume adjusting operation; and
a sixth step (23, S6) of holding the level calculated by the fifth steps (20, 28, S6) as the limitation level.

10. An audio outputting method according to claim 6, **characterized by** further comprising:
seventh steps (20 to 23) of making the fourth step (18, S9) select whether the level limitation is applied to the audio signal that is reproduced by the first step (15).
